(19) Europäisches Patentamt
European Patent Office
Office européen des brevets

(11) **EP 2 705 535 B1**

(12) **EUROPÄISCHE PATENTSCHRIFT**

(45) Veröffentlichungstag und Bekanntmachung des Hinweises auf die Patenterteilung:
**22.04.2015 Patentblatt 2015/17**

(21) Anmeldenummer: **12718269.9**

(22) Anmeldetag: **07.05.2012**

(51) Int Cl.:
*H01L 27/146* (2006.01)     *G02B 5/18* (2006.01)
*H01L 31/0216* (2014.01)     *G01J 3/28* (2006.01)

(86) Internationale Anmeldenummer:
**PCT/EP2012/058367**

(87) Internationale Veröffentlichungsnummer:
**WO 2012/152753 (15.11.2012 Gazette 2012/46)**

(54) **VORRICHTUNG ZUR ERFASSUNG DES SPEKTRUMS ELEKTROMAGNETISCHER STRAHLUNG INNERHALB EINES VORGEGEBENEN WELLENLÄNGENBEREICHS**

DEVICE FOR DETECTING THE SPECTRUM OF ELECTROMAGNETIC RADIATION WITHIN A SPECIFIED WAVELENGTH RANGE

DISPOSITIF DE DÉTECTION DU SPECTRE D'UN RAYONNEMENT ÉLECTROMAGNÉTIQUE À L'INTÉRIEUR D'UN DOMAINE DE LONGUEUR D'ONDE PRÉDÉFINI

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.05.2011 EP 11165145**
**25.05.2011 EP 11167479**
**05.07.2011 US 201161504456 P**

(43) Veröffentlichungstag der Anmeldung:
**12.03.2014 Patentblatt 2014/11**

(73) Patentinhaber: **ELMOS Semiconductor AG**
**44227 Dortmund (DE)**

(72) Erfinder:
• **BURCHARD, Bernd**
**44227 Dortmund (DE)**
• **BUDDE, Wolfram**
**44227 Dortmund (DE)**

(74) Vertreter: **Von Kreisler Selting Werner - Partnerschaft**
**von Patentanwälten und Rechtsanwälten mbB**
**Deichmannhaus am Dom**
**Bahnhofsvorplatz 1**
**50667 Köln (DE)**

(56) Entgegenhaltungen:
**EP-A1- 2 251 718     WO-A1-2009/011439**
**WO-A2-2009/106316     US-A1- 2006 044 429**
**US-A1- 2008 170 143     US-A1- 2010 176 280**

## Beschreibung

Die Erfindung betrifft eine Vorrichtung zur Erfassung des Spektrums elektromagnetischer Strahlung innerhalb eines vorgegebenen Wellenlängenbereichs (Spektrometer), die unter Verwendung von Prozessschritten für die Halbleiterbauelementfertigung und damit recht kleinformatig herstellbar ist.

Spektrometer sind in den unterschiedlichsten Ausführungsformen bekannt. Bei einem Spektrometer trifft die zu untersuchende elektromagnetische Strahlung auf eine Vielzahl von strahlungsempfindlichen Sensorelementen auf, die für Strahlung in unterschiedlichen Frequenzbändern innerhalb des interessierenden Frequenzbereichs, d.h.. für Strahlung mit unterschiedlichen Wellenlängen innerhalb des interessierenden Wellenlängenbereichs empfindlich sind. Somit kann also die Intensität der Strahlung über deren interessierenden Wellenlängenbereich messtechnisch erfasst werden.

Die wellenlängenselektiven Sensorelemente können dabei beispielsweise durch Fotodioden realisiert werden, denen unterschiedlich breite Schlitzblenden oder dergleichen Lochblenden zugeordnet sind. Beispiele für derartige Festkörper-Spektrometer finden sich in EP-A-1 475 963 und EP-A-1 517 374. Bei den Spektrometern gemäß dieser beiden Schriften werden die Lochblenden jeweils durch eine einzige Lochmaske gebildet, wobei die die Löcher definierenden Ränder der Fenster der Lochmaske von Lochblende zu Lochblende betrachtet jeweils verschiedene Abstände aufweisen. Dass Schlitz und Lochblenden wellenlängenselektiv wirken, ist seit langem bekannt (siehe z.B. aus P. Morse, P.J. Rubenstein; The Diffraction of Waves by Ribbons and by Slits; Physical Review; Vol. 54; Dec. 1st 1938; p. 895-898). Die Herstellung solcher Lochblenden für optische Komponenten setzt einen hochpräzisen Fertigungsprozess im nm Maßstab voraus, was die Herstellung und Reproduzierbarkeit der Lochmaske betrifft.

In der chemischen, biochemischen, medizinischen und forensischen Analytik spielt die Spektrometrie eine wesentliche Rolle. Daher ist die Verfügbarkeit eines einfach herstellbaren Spektrometers eine wesentliche Voraussetzung für die Breite Anwendung einer Real-Time-Spektromie bzw. einer flächendeckenden Spektrometrie z.B. in der Medizintechnik, in der Landwirtschaft oder allgemein in der Industrie. Das Problem hierbei ist ein präzises, energieselektives optisches Funktionselement kostengünstig herstellen zu können. Praktisch alle Spektrometer verfügen heute über mikroelektronische Schaltkreise, die typischerweise in CMOS-Technologie hergestellt sind.

Aufgabe der Erfindung ist es, eine Festkörper-Vorrichtung zur Erfassung des Spektrums elektromagnetischer Strahlung innerhalb eines vorgegebenen Wellenlängenbereichs zu schaffen, die sich auf einfache Art und Weise durch Prozessschritte der Halbleiterbauelementeherstellung realisieren lässt.

Aus US-A-2006/0044429 ist eine Vorrichtung zur Erfassung des Spektrums elektromagnetischer Strahlung bekannt, bei der nach dem Prinzip der Interferenz gearbeitet wird (siehe den Absatz 167 dieser Druckschrift).

In US-A-2010/0176280 ist ein optisches Element mit einem optischen Filter beschrieben, das aus zwei Filterelementen besteht, wobei mindestens eines der Filterelemente ein metallisches optisches Filter ist.

In WO-A-2009/106316 ist ein multispektraler Bildsensor beschrieben, der konzentrische Ringschlitze aufweist.

US-A-2008/0170143 zeigt ein bildaufnehmendes Element, bei dem eine Lochblende vorgesehen ist, die innerhalb verschiedener Teilbereiche verschiedene Lochabstände aufweist.

Schließlich zeigt EP-A-2 251 718 ein metallisches optisches Filter, das photolitographisch herstellbar ist.

Zur Lösung dieser Aufgabe wird mit der Erfindung eine Vorrichtung zur Erfassung des Spektrums elektromagnetischer Strahlung innerhalb eines vorgegebenen Wellenlängenbereichs vorgeschlagen, wobei die Vorrichtung versehen ist mit den Merkmalen des Anspruchs 1. Einzelne Ausgestaltungen der Erfindung sind jeweils Gegenstand der Unteransprüche.

Das erfindungsgemäße Festkörper-Spektrometer zeichnet sich durch ein Substrat, insbesondere ein Halbleitersubstrat, aus, auf dem zwei Lochmasken übereinander angeordnet sind. Jede der beiden Lochmasken weist dabei ein Material auf, das für elektromagnetische Strahlung innerhalb des interessierenden Wellenlängenbereichs undurchlässig ist. Jede der beiden Lochmasken ist ferner mit einer Vielzahl von ersten bzw. zweiten Fenstern versehen. Die Größe dieser Fenster und die Form der Berandung werden dabei zweckmäßigerweise so gewählt, dass parasitäre Resonanzen minimiert insbesondere in Form von stehenden Wellen minimiert werden. Unter einer Resonanz in diesem Sinne ist zu verstehen, dass eine elektromagnetische Welle mehrfach auf sich selbst zurückgeworfen wird und dabei keine oder nur eine sehr geringe Phasenverschiebung auftritt, sodass es zu einer konstruktiven Interferenz beispielsweise wie bei einem Fabry-Perot-Interferometer kommt. Vorzugsweise ist das Lochmaskenmaterial oder eine Beschichtung der Lochmasken für die Strahlung innerhalb des interessierenden Wellenlängenbereichs undurchlässig und/oder nicht reflektiv und/oder nicht refraktiv und/oder absorbierend. Das bedeutet, dass Resonanzstrecken, die das Lochmaskenmaterial enthalten, maximal bedämpft werden, und zwar vorzugsweise durch Maximierung der Lichtabsorption oder Streuung in eine unschädliche Richtung. Innerhalb des Substrats befinden sich eine Vielzahl von für Strahlung innerhalb des interessierenden Wellenlängenbereichs empfindliche Sensorelemente.

Die beiden Lochmasken sind relativ zueinander derart angeordnet, dass sich ihre Fenster mehr oder weniger überlappen. Dabei ist der Lochabstand beider Lochmasken geringfügig verschieden voneinander, so dass der Überlappungsgrad benachbarter Fenster der beiden Lochmasken variiert. Hierdurch entstehen unterschiedlich große Löcher

EP 2 705 535 B1

bzw. Strahlungsdurchlässe aus jeweils zwei sich überlappenden Fenstern der beiden Lochmasken. Die Fenster weisen aufgrund der endlichen Dicke des Lochmaskenmaterials oberhalb der Oberfläche des Substrates angeordnete, in der Oberseite der Lochmasken liegende Öffnungen auf. Um die Bedämpfung der durch die Kanten mit anderen spiegelnden Flächen in der Konstruktion gebildeten Resonanzstrecken zu maximieren werden die gegenüberliegenden Ränder der Fenster der beiden Lochmasken, die die Strahlungsdurchlässe bilden, dabei gegensinnig angeschrägt, was eine schräg gerichtete Weiterausbreitung des Lichts nach dem Durchgang durch den Strahlungsdurchlass zur Folge hat und damit eine Resonanz zwischen den Lochmasken und der Substratoberfläche durch Streuung des Lichts aus der Konstruktion heraus vermeidet bzw. durch Senkung der Resonatorgüte minimiert. Jedem dieser Löcher bzw. Strahlungsdurchlässe ist ein Sensorelement, und zwar typischerweise insbesondere genau ein Sensorelement zugeordnet, so dass sich letztendlich wellenlängenselektive Sensorelemente ergeben. Die beiden Lochmasken wirken also als Filter zur wellenlängenabhängigen Dämpfung und damit anders als im Stand der Technik, wo in US-A-2006/0044429 andere physikalische Dispersions- und Interferenz-Effekte genutzt werden. US-A-2006/0044429 nutzt im Gegensatz zu erfindungsgemäßen Vorrichtung ausdrücklich wellenlängenabhängige Interferenzen und Resonanzen zur Selektion verschiedener Farben (vergl. Fig. 15, 16, 17 in US-A-2006/0044429). Daher verfügt jeder der Schlitze (z.B. Fig. 41, Element 7 & 7b in US-A-2006/0044429) im Gegensatz zur erfindungsgemäßen Vorrichtung auch über mehrere Detektoren. In dem konkreten Fall verfügen die Schlitze über einen Blau-Detektor (Fig. 41, Element 12B in US-A-2006/0044429), zwei Grün-Detektoren links und rechts der Schlitzstruktur (Fig. 41, Element 12G in US-A-2006/0044429), und zwei Rot-Detektoren links und rechts der Schlitzstruktur (Fig. 41, Element 12R in US-A-2006/0044429), die mit der nächsten Struktur zur Platzersparnis geteilt werden. Die Auflösung dieser Struktur aus dem Stand der Technik ist naturgemäß aufgrund der kleinen optischen Weglänge begrenzt und gegebenenfalls nur für wenige Farben geeignet, im konkreten Beispiel die Farben rot, grün und blau. Auch würde der Platz für die Detektoren bei mehr Farben nicht ausreichen. Die Konstruktion der in US-A-2006/0044429 offengelegten Vorrichtung ist also auch nicht geeignet, eine höhere Auflösung zu erreichen und damit den Zweck der vorliegenden Erfindung zu erfüllen. Erfindungsgemäß sind also die Löcher bzw. Strahlungsdurchlässe nicht durch die Ränder der Fenster einer einzigen Lochmaske, sondern durch die sich gegenüberliegenden Ränder der sich überlappenden Fenster zweier Lochmasken gebildet. Damit wird die Größe der einzelnen Löcher bzw. Strahlungsdurchlässe durch die Positionierung der beiden Lochmasken definiert. Die Positionsgenauigkeit, mit der unter Verwendung von Fotolithographieschritten in der Halbleiterbauelementfertigung zwei Lochmasken beispielsweise durch Polysiliziumbahnen oder metallisierte Bahnen hergestellt werden können, ist wesentlich größer als die Genauigkeit, mit der der Abstand der ein Fenster innerhalb einer Lochmaske definierenden Ränder gefertigt werden kann. Bei Herstellung einer genügend großen Anzahl von durch sich überlappende Fenster zweier Lochmasken ergebenden Strahlungsdurchlässen mit diesen zugeordneten Sensorelementen wird man unabhängig von der Fertigungsgenauigkeit und Positionsgenauigkeit stets eine Anzahl von Sensorelementen innerhalb des Substrats ausmachen können, deren Wellenlängenselektivität innerhalb des interessierenden Wellenlängenbereichs liegt. Nach der Herstellung des erfindungsgemäßen Spektrometers bedarf es dann also lediglich noch der Kalibration, um aus der Vielzahl von hergestellten wellenlängenselektiven Sensorelementen (Sensorelement mit Strahlungsdurchlass) diejenigen nebeneinanderliegenden Sensorelemente zu identifizieren, deren Wellenlängenselektivität innerhalb des interessierenden Wellenlängenbereichs liegt.

Mit der Erfindung wird also ein Festkörper-Spektrometer vorgeschlagen, bei dem eine spezielle Lochblendenkonstruktion als optisches Filter verwendet wird. Entscheidend für die Erfindung ist dabei der Gedanke, dass mit Hilfe zweier Lithographie-Ebenen (die beiden Lochmasken befinden sich in unterschiedlichen, vorzugsweise direkt aneinandergrenzenden Ebenen) besonders kleine Blenden hochgenau hergestellt werden können. Die Schlitzbreite bzw. die Abmessungen der Strahlungsdurchlässe dürfen $\lambda/4$ nicht überschreiten, wobei mit $\lambda$ die jeweilige Wellenlänge bezeichnet ist. Im UV-Bereich ergeben sich dann Schlitzbreiten von wenigen nm. Diese sind mit einfachen CMOS-Technologieherstellungsschritten anders als nach der Erfindung vorgeschlagen, nicht zu fertigen. Mit der Erfindung wird also eine Konstruktion für ein Spektrometer angegeben, das sich extrem kostengünstig, nämlich unter Verwendung einfacher CMOS-Technologien, herstellen lässt. Damit ist das erfindungsgemäße Spektrometer kostengünstig als Massenprodukt herstellbar.

Die Ausbildung der Sensorelemente kann unterschiedlich erfolgen. Beispielsweise ist es denkbar, die Sensorelemente als Fotodioden auszubilden. Aber auch Thermopile-Elemente sind realisierbar im Rahmen des erfindungsgemäßen Festkörper-Spektrometers. Ganz allgemein ist es zweckmäßig, wenn die strahlungsempfindlichen Sensorelemente jeweils zwei unterschiedliche, elektrisch leitende und in Kontakt miteinander stehende, bei Empfang von elektromagnetischer Strahlung innerhalb des vorgegebenen Wellenlängenbereichs einen veränderbaren elektrischen Parameter (beispielsweise Strom, Spannung, Widerstand, Kapazität, Induktivität, Leistung) erzeugende Materialien aufweisen, wobei die Größe der erzeugten Spannung von der Intensität der Strahlung abhängig ist.

Das erfindungsgemäße Spektrometer kann sozusagen eindimensional ausgeführt sein, indem die sich durch die überlappenden Fenster der Lochmasken ergebenden, unterschiedlich großen Strahlungsdurchlässe in einer Zeile oder Reihe nebeneinanderliegend angeordnet sind. Dabei ist es zweckmäßig, wenn die Strahlungsdurchlässe als Schlitze unterschiedlicher Breite ausgeführt sind. Bei einer derartigen Ausgestaltung der Erfindung sollte oberhalb der Lochmasken (und ggf. oberhalb einer strahlungsdurchlässigen Passivierungsschicht) ein Polarisationsfilter angeordnet sein.

Dieses Polarisationsfilter dient zur Abschirmung von elektromagnetischen Wellen, deren E Feld-Vektoren quer zur Schlitzbreite verläuft, und zum Hindurchlassen von Strahlung mit elektromagnetischen Wellen, deren E-Feld-Vektoren in Schlitzbreitenerstreckung verlaufen.

Bei der zuvor beschriebenen Variante ist also gemäß einer vorteilhaften Ausgestaltung der Erfindung vorgesehen, dass die ersten und zweiten Fenster der beiden Lochmasken sich jeweils über Flächen erstrecken, die längs zweier zueinander rechtwinkliger Aufspannachsen aufgespannt sind, dass die Abmessungen der ersten und zweiten Fenster in zumindest einer gemeinsamen ersten Achse der beiden Aufspannachsen jeweils von einem ersten und einem zweiten Begrenzungsrand des betreffenden Fensters begrenzt sind, wobei, in einer gemeinsamen ersten Achse betrachtet, jeder Strahlungsdurchlass von einem ersten Begrenzungsrand eines ersten Fensters der ersten Lochmaske und einem zweiten Begrenzungsrand eines das erste Fenster überlappenden zweiten Fensters der zweiten Lochmaske begrenzt ist, und dass der erste Abstand der ersten Begrenzungsränder jeweils benachbarter erster Fenster der ersten Lochmaske von dem zweiten Abstand der zweiten Begrenzungsränder jeweils benachbarter zweiter Fenster der zweiten Lochmaske verschieden ist, wobei oberhalb der Anordnung der Lochmasken ein Polarisationsfilter zum Abschirmen von Strahlung mit elektromagnetischen Wellen, deren E-Feld-Vektor rechtwinklig zur ersten Aufspannachse verläuft, und zum Hindurchlassen von Strahlung mit elektromagnetischen Wellen, deren E-Feld-Vektor parallel zur ersten Aufspannachse verläuft.

Auf ein Polarisationsfilter der zuvor genannten Art kann dann verzichtet werden, wenn dafür gesorgt wird, dass die Abmessungen der Strahlungsdurchlässe in zwei rechtwinklig zueinander verlaufenden Aufspannachsen so gewählt sind, dass sie wellenlängenselektiv wirken. Hierbei ist dann also vorgesehen, dass die Abmessungen der ersten und zweiten Fenster auch in der gemeinsamen zweiten Achse der beiden Aufspannachsen jeweils von einem dritten und einem vierten Begrenzungsrand des betreffenden Fensters begrenzt sind, wobei, in der gemeinsamen zweiten Aufspannachse betrachtet, jeder Strahlungsdurchlass von einem dritten Begrenzungsrand des ersten Fensters der ersten Lochmaske und einem vierten Begrenzungsrand eines das erste Fenster überlappenden zweiten Fensters der zweiten Lochmaske begrenzt ist.

Wie bereits oben erwähnt, lassen sich die Lochmasken aus lichtundurchlässigem Material mit Hilfe fotolithographischer Prozesse herstellen, wie sie beispielsweise bei einem CMOS-, BICMOS- oder Bipolar-Bauelement-Herstellungsverfahren angewendet werden. Sämtlichen dieser Prozesse gemeinsam ist der Umstand, dass der Abstand gleicher Begrenzungskanten jeweils benachbarter Fenster jeder der beiden Lochmasken eine gleichbleibende erste Toleranz (von z.B. 2 nm) sowie die Positionierung der beiden Lochmasken relativ zueinander eine zweite Toleranz (von z.B. 200 nm) und die Größe der Fenster eine dritte Toleranz (typischerweise von ebenfalls ca. 200nm) aufweist, wobei letztere bei sehr kleinen Fenstergrößen deren Fertigung in einer Ebene verhindert. Daher ist die erste Toleranz mathematisch um mindestens eine Größenordnung, vorzugsweise mindestens zwei Größenordnungen kleiner ist als die zweite und dritte Toleranz. Ursache hierfür ist, dass bei fotolithografischen Prozessen, die erste Toleranz die Präzision der verwendeten Masken widerspiegelt, während die zweite Toleranz die Präzision widerspiegelt, mit der Masken zu einander bzw. relativ zu einem gegebenen Substrat positioniert werden können und die dritte Toleranz die Präzision der typischerweise angewendeten Ätzprozesse zur Fertigung der Lochblenden widerspiegelt.

Wie bereits weiter oben erwähnt, handelt es sich bei den Sensorelementen beispielsweise um Fotodioden, die im Substrat integriert sind. Zweckmäßigerweise wird dabei die auf dem Substrat ausgebildete erste Lochmaske zur Herstellung selbstjustierter Fotodioden im Substrat verwendet. Dabei ist dann vorgesehen, dass in dem Substrat von dessen Oberseite aus ein mit ersten Ladungsträgern von einem ersten Leitungstyp versehenes Gebiet ausgebildet ist, wobei in dem Gebiet mit den ersten Fenstern der ersten Lochmaske fluchtende und innerhalb der Fenster freiliegende Teilgebiete mit zweiten Ladungsträgern von einem dem ersten Leitungstyp entgegengesetzten zweiten Leitungstyp ausgebildet sind, die mit den jeweils angrenzenden Bereichen des Gebiets aus den ersten Ladungsträgern eine Fotodiode bilden.

Anwendungsbereiche des erfindungsgemäßen Spektrometers sind beispielsweise:

- Flüssigkeitsüberwachung (beispielsweise Überwachung der Qualität von Brennstoffen)
- Gasdetektoren
- Biosensoren (Eine Beschichtung oberhalb der Passivierung reagiert mit einem zu messenden Inhaltsstoff der zu testenden Flüssigkeit. Diese Reaktib verändert den Brechungsindex und damit die charakteristische spektrale Frequenz an den Gitter-Pforten)
- DNA Detektoren (Die DNA wird mittels Elektrophorese in einem Medium bewegt und durch UV-Stahlung zu einer charakteristischen Fluoreszenz angeregt, die detektiert wird.)
- Sensoren zur Beurteilung des Gesundheitszustands eines Patienten aufgrund des Haut-Spektrums
- Partikelzähler (das Spektrum des Streulichts ist abhängig von der Größe des Partikels)
- IR-Spektrometer
- Laser-Spektrometer
- Mikrowellenspektrometer

- Multi-Colour Bar-Codes
- mikropotische Demodulation für frequenzgemultiplexte optische Signale
- Frequenzselektive Verfahren für optoelektronische Anwendungen wie beispielsweise Lichtschranken etc. zur Verbesserung des Störabstandes
- Detektion von mit Mikroben befallenen Lebensmitteln und Futtermitteln
- Bestimmung des Feuchtegehaltes in Stoffen (z.B. Futtermitteln)
- Märkte: Agrar, Chemie, Glasindustrie, Lebensmittel

Die Erfindung wird nachfolgend anhand verschiedener Ausführungsbeispiele und unter Bezugnahme auf die Zeichnung näher erläutert. Im Einzelnen zeigen dabei:

Fig. 1          einen Querschnitt durch einen Teil des Aufbaus eines Festkörper-Spektrometers gemäß einem ersten Ausführungsbeispiel,

Fig. 2          einen Querschnitt gemäß einem Beispiel des Spektrometers, welches nicht Teil der Erfindung ist,

Fig. 3          die Verwendung des Festkörper-Spektrometers in Kombination mit einem Polarisationsfilter,

Fig. 4          andeutungsweise ein weiteres Ausführungsbeispiel eines Spektrometers im Querschnitt mit Thermopile-Elementen als strahlungsselektive Elemente,

Fig. 5          eine Draufsicht auf den erfindungsgemäß vorgesehenen Versatz der Fenster zweier Lochmasken in zwei Dimensionen,

Fig. 6          als Blockschaltbild für eine Beschaltung des Spektrometers zur Auswertung der empfangenen Strahlung,

Fig. 7          ein Beispiel für eine Signalauswertung zur Lieferung der Intensitäten des untersuchten Spektrums,

Fign. 8 und 9   Diagramme zur Verdeutlichung der Grundlagen für die Auswertung der Signale des Spektrometers,

Fig. 10         ein FDTD-Modell eines Schlitzes auf Si-Substrat und

Fig. 11         eine Darstellung der wellenlängenabhängigen Intensität des E-Feldes in Abhängigkeit von der Schlitzbreite.

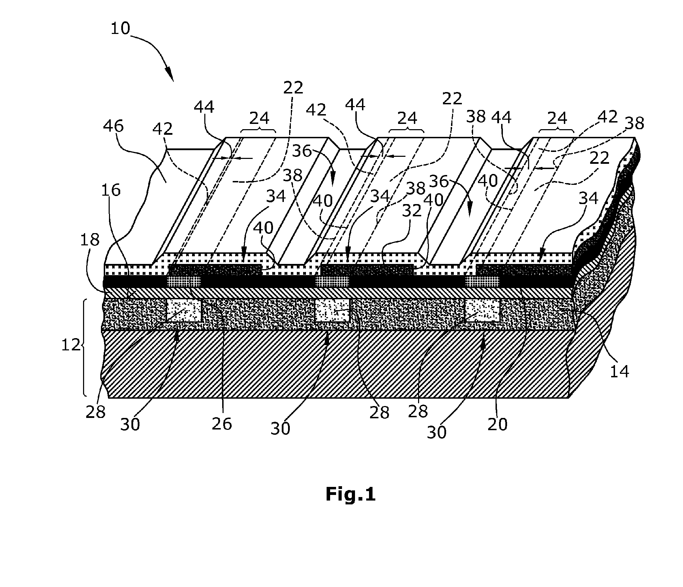

In Fig. 1 ist perspektivisch und in Schnittansicht ein Teil eines beispielhaften Festkörper-Spektrometers 10 gemäß einem ersten Ausführungsbeispiel gezeigt. Das Festkörper-Spektrometer 10 weist ein im Regelfall schwach p-dotiertes (Silizium-)Halbleitersubstrat 12 auf, in dessen oberflächennahen Bereich ein n-dotiertes (Wannen-)Gebiet 14 implantiert ist. Auf der Oberseite 16 des Halbleitersubstrats 12 befindet sich eine Siliziumoxid-Schicht 18. Auf der Siliziumoxid-Schicht 18 befindet sich eine erste Lochmaske 20 aus beispielsweise polykristallinem Silizium. Diese erste Lochmaske 20 weist erste schmale Fenster 22 mit jeweils gleicher Breite 24 auf. Diese Fenster 22 sind in diesem Ausführungsbeispiel mit einem für die interessierende Strahlung durchlässigen Material 26 ausgefüllt. Das Material der ersten Lochmaske 20 ist für Strahlung im interessierenden Wellenlängenbereich undurchlässig und absorbierend, d.h. z.B. nicht reflektiv und/oder nicht refraktiv.

Nach dem Aufbringen der ersten Lochmaske 20 (und vor dem Ausfüllen der ersten Fenster 22) wird durch die ersten Fenster 22 hindurch eine p-Implantation vorgenommen, so dass sich in dem n-dotierten Gebiet 14 p-dotierte Bereiche 28 ausbilden. Mithin entstehen pn-Übergänge, die für die interessierende Strahlung sensitive Fotodioden 30 bilden.

Auf der ersten Lochmaske 20 befindet sich eine zweite Lochmaske 32, die beispielsweise aus Metall bzw. einer Metalllegierung besteht und ebenfalls für die Strahlung im interessierenden Wellenlängenbereich undurchlässig und absorbierend, d.h. z.B. nicht reflektiv und/oder nicht refraktiv ist. Die zweite Lochmaske 32 weist zwischen ihren für die Strahlung undurchlässigen Bereichen 34 zweite Fenster 36 auf. Die zweiten Fenster 36 der zweiten Lochmaske 32 überlappen dabei teilweise die ersten Fenster 22 der ersten Lochmaske 20, wobei gegenüberliegende Längsränder 38,40 der sich überlappenden ersten Fenster 22 der ersten Lochmaske 20 bzw. der zweiten Fenster 36 der zweiten Lochmaske 32 unterschiedlich breite Strahlungsdurchlässe 42 bilden. Dies ist darin begründet, dass der Mittenabstand (Pitch) der gleichmäßig beabstandeten benachbarten ersten Fenster 22 verschieden ist von dem Mittenabstand (Pitch) der ebenfalls gleichmäßig beabstandeten benachbarten zweiten Fenster 36. Dadurch entsteht ähnlich wie bei einem Nonius eine sich von Strahlungsdurchlass 42 zu Strahlungsdurchlass 42 verändernde Spaltbreite 44. Durch die Bildung der Strahlungsdurchlässe 42 mittels zweier Lithographie-Ebenen lässt sich die Veränderung der Spaltbreite 44 der nebeneinanderliegenden Strahlungsdurchlässe 42 extrem genau steuern und einstellen. Die Herstellungsgenauigkeit der Kanten 38 zu benachbarten Kanten 38 der Lochmaske 20 bzw. der Kanten 40 zu benachbarten Kanten 40 der Lochmaske 32 ist extrem hoch (bei normalen CMOS-Prozessen beispielsweise im einstelligen nm-Bereich), wohingegen die beiden Toleranzen, was die Größen der ersten bzw. zweiten Fenster 22, 36 sowie die Präzision, mit der ein Fenster 22 der ersten Lochmaske gegenüber einem Fenster 36 der zweiten Lochmaske justiert werden kann, betrifft, um etwa zwei Größenordnungen größer sind, also typischerweise im dreistelligen nm-Bereich liegen. Auf der zweiten Lochmaske 32 befindet sich eine zumindest im interessierenden Wellenlängenbereich strahlungsdurchlässige Passivierungsschicht 46.

Für die hochpräzise Herstellung des Festkörper-Spektrometers gemäß Fig. 1 bzw. gemäß der Erfindung ist auch nicht entscheidend, dass bestimmte Strahlungsdurchlässe 42, d.h. bezüglich ihrer Lage auf dem gefertigten Chip festgelegte Strahlungsdurchlässe 42 die jeweils vorgeschriebenen Spaltbreiten aufweisen. Vielmehr lässt sich das erfindungsgemäß Festkörper-Spektrometer derart herstellen, dass wesentlich mehr Strahlungsdurchlässe mit diesen zugeordneten Fotodioden bzw. strahlungsempfindlichen Elementen hergestellt werden, als benötigt werden. Durch einen der Herstellung nachgeschalteten Prozess werden dann im Rahmen der Kalibration des Festkörper-Spektrometers diejenigen Strahlungsdurchlässe 42 mit den gewünschten Variationen an Spaltbreiten ausgewählt, die für den interessierenden Wellenlängenbereich benötigt werden.

Durch die sich mit gleichbleibendem Pitch in ihrer Spaltbreite ändernden Strahlungsdurchlässe 42 treten nun durch jede dieser Öffnungen unterschiedliche Strahlungsanteile hindurch. Auf die Fig. 1 bezogen bedeutet dies insbesondere, dass durch den links dargestellten Strahlungsdurchlass 42 Strahlung bis zu einer durch die Spaltbreite 44 dieses Strahlungsdurchlasses bestimmten Wellenlänge hindurchtritt. Durch den mittleren Strahlungsdurchlass 42 tritt neben Strahlung mit Wellenlängen, wie sie durch den linken Strahlungsdurchlass treten, weitere Strahlung mit Wellenlängen hindurch, die letztendlich durch die größere Spaltbreite 44 bestimmt ist. (Siehe P. Morse, P.J. Rubenstein; The Diffraction of Waves by Ribbons and by Slits; Physical Review; Vol. 54; Dec. 1st 1938; p. 895-898.) Entsprechend lässt damit der in Fig. 1 rechts gezeigte noch breitere Strahlungsdurchlass 42 Strahlung mit denjenigen Wellenlängen hindurch, die auch den mittleren Strahlungsdurchlass 42 passieren, wobei zusätzlich noch Strahlung mit größeren Wellenlängen den rechten Strahlungsdurchlass 42 passiert.

Dieser Umstand wird, wie später noch beschrieben werden wird, bei der Auswertung der Strahlungsintensitäten innerhalb des interessierenden Spektrums berücksichtigt.

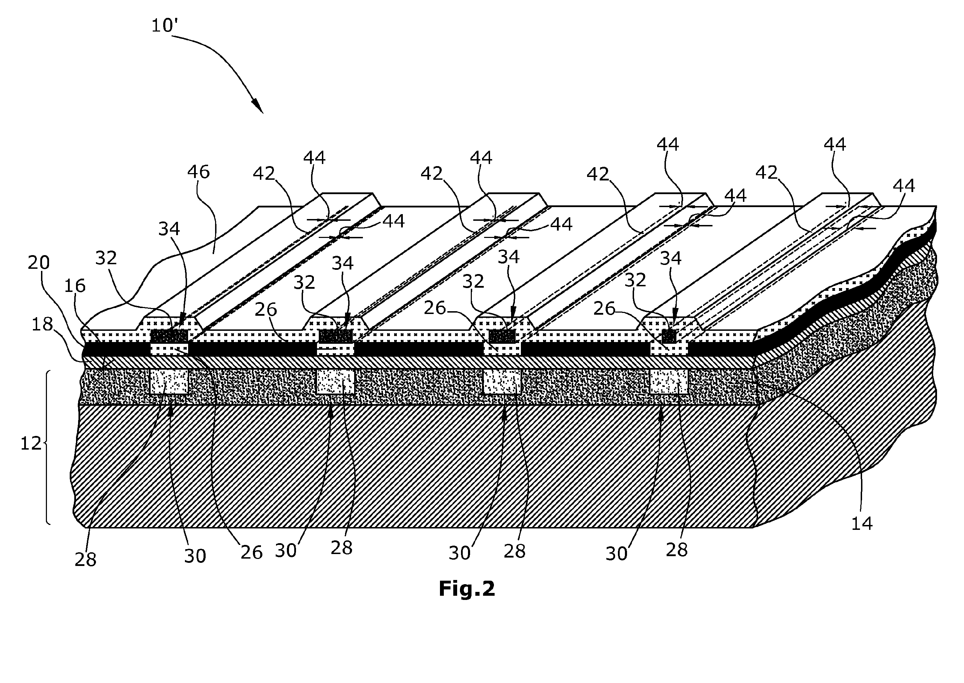

Fig. 2 zeigt ein alternatives Beispiel für ein Festkörper-Spektrometer 10', wobei in Fig. 2 diejenigen Schichten und Elemente, die denjenigen des Spektrometers 10 gemäß Fig.1 entsprechen bzw. gleichen, mit den gleichen Bezugszeichen wie in Fig. 1 versehen sind.

Wie man erkennt, entspricht der Aufbau des Festkörper-Spektrometers 10' einschließlich der ersten Lochmaske 20 demjenigen des Spektrometers 10 der Fig. 1. Im Unterschied zum Spektrometer 10 der Fig. 1 weist die zweite Lochmaske 32 des Spektrometers 10' der Fig. 2 strahlungsundurchlässige Bereiche 34 auf, die mittenzentriert oberhalb der ersten Fenster 22 der ersten Lochmaske 20 angeordnet sind. Beidseitig dieser strahlungsundurchlässigen Bereiche 34 ergeben sich dann spaltförmige Strahlungsdurchlässe 42 mit paarweise jeweils gleichen Spaltbreiten 44.

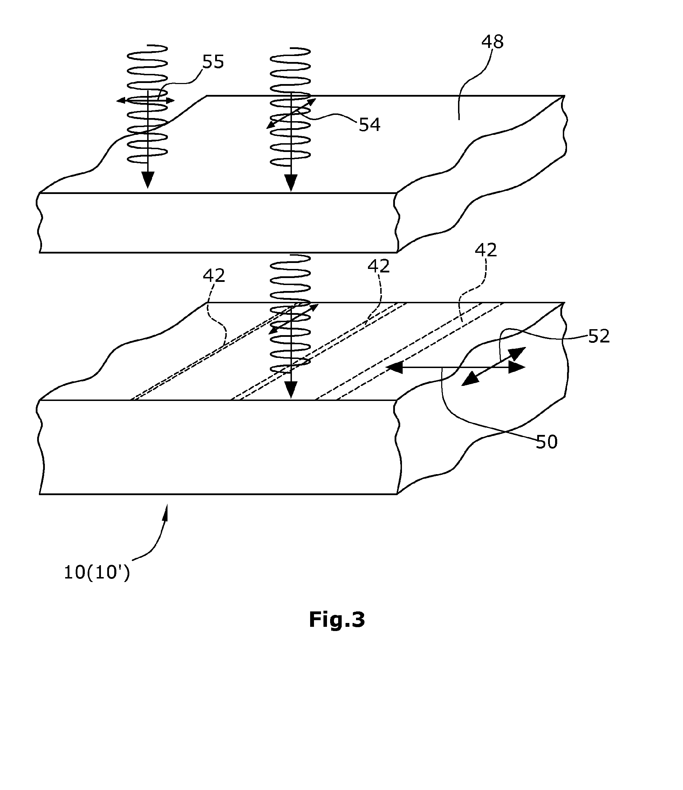

Fig. 3 zeigt schematisch die Verwendung eines Polarisationsfilters 48 in Verbindung mit dem Festkörper-Spektrometer 10 bzw. 10' der Fign. 1 bzw. 2. Die Strahlungsdurchlässe 42 weisen in der (ersten) Aufspannachse 50, in der sich die ersten und zweiten Fenster 22, 36 erstrecken, eine sich verändernde Spaltbreite auf (wie oben beschrieben). In der zur ersten Aufspannachse 50 rechtwinkligen verlaufenden Aufspannachse 52 weisen die Strahlungsdurchlässe 42 im Wesentlichen gleiche Abmessungen auf. Die Wellenlängenselektivität entsteht also in der ersten Aufspannachse 50, so dass das Polarisationsfilter 48 für eine entsprechende Filterung der einfallenden zu untersuchenden Strahlung sorgt. Dies ist in Fig. 3 gezeigt. Wird Strahlung mit einem E-Feld-Vektor 54, der in Längserstreckung (Achse 52) der schlitzförmigen Strahlungsdurchlässe 42 verläuft, hindurch gelassen, während Strahlung, deren E-Feld-Vektor 55 in Breitenerstreckung der schlitzförmigen Strahlungsdurchlässe 42 verläuft (siehe Achse 50) blockiert und abgeschirmt wird.

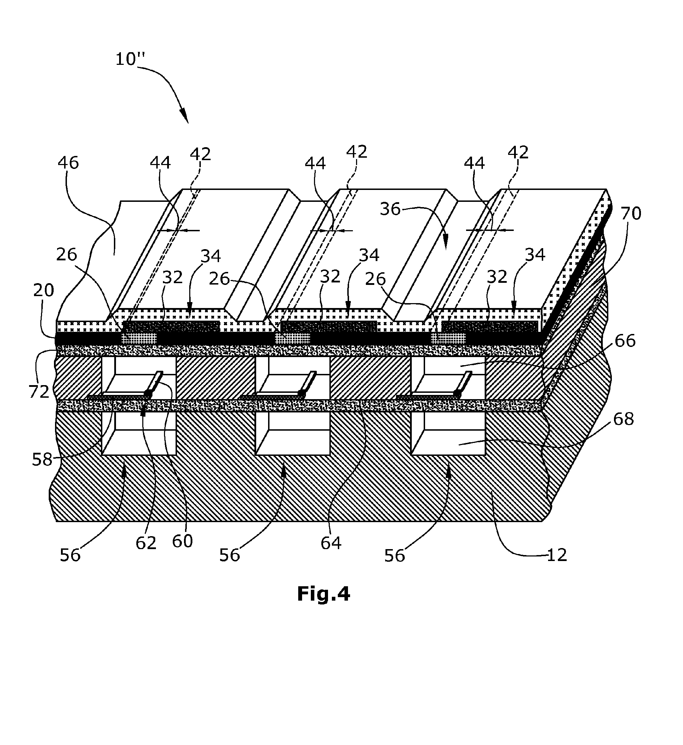

Fig. 4 zeigt ein weiteres Ausführungsbeispiel eines Festkörper-Spektrometers 10", wobei auch hier gilt, dass diejenigen Schichten und Bestandteile, die identisch bzw. funktionsgleich mit denjenigen des Spektrometers 10 gemäß Fig. 1 sind, in Fig. 4 mit den gleichen Bezugszeichen wie in Fig. 1 versehen sind.

Der obere Teil des Festkörper-Spektrometers 10" der Fig. 4 ist identisch mit den oberhalb der Siliziumoxid-Schicht 18 und oberhalb dieser angeordneten Schichten gemäß Fig. 1 (erste und zweite Lochmasken 20, 32 sowie Passivierungsschicht 46).

Anstelle der Fotodioden 30 der Festkörper-Spektrometer 10 und 10' der Fign. 1 und 2 sind bei dem Spektrometer 10" gemäß Fig. 4 als strahlungsempfindliche Elemente Thermopile-Elemente 56 vorgesehen. Jedes Thermopile-Element 56 besteht dabei aus zwei Leitern 58, 60, die an einem Überkreuzungspunkt 62 elektrisch miteinander in Verbindung stehen. Die beiden Leiter 58, 60 weisen Materialien mit unterschiedlicher Austrittsarbeit auf. Hierbei kann es sich beispielsweise um Paarungen von n-dotiertem und p-dotiertem Silizium oder aber von polykristallinem Silizium und Metall (Aluminium) handeln. Auf Grund der unterschiedlichen Austrittsarbeiten kommt es zur Ausbildung einer Thermospannung zwischen den beiden Leitern 58,60 am Ort des elektrischen Kontaktes (Überkreuzungspunkt 62). Die Thermospannung hängt ab von der Temperatur des Kontaktes. Der Überkreuzungspunkt 62 wird im Ausführungsbeispiel gemäß Fig. 4 durch eine (Silizium-)Membran 64, auf der sich die Leiter 58,60 befinden, sowie über das Substrat 12 (unbeabsichtigt) gekühlt. Um diese Kühlung zu minimieren, wird die Membran 64 typischerweise möglichst dünn ausgeführt. Aus dem gleichen Grund, nämlich der Minimierung der Kühlung, werden oberhalb und unterhalb der Membran 64 in dem Substrat 12 Kavitäten 66,68 ausgebildet, die evakuiert sind. Diese Kavitäten 66,68 entstehen beispielsweise durch mikromechanisch vorgefertigte Wafer, die miteinander verbondet, d.h. schmelzkontaktiert werden, wie es von der Fertigung von beispielsweise MEMS-Drucksensoren mit Buried Cavities bekannt ist.

Der obere Wafer 70 ist typischerweise entweder als Isolator gefertigt oder mit einer zusätzlichen in Fig. 4 aus Gründen der Vereinfachung nicht dargestellten Isolationsschicht versehen, um die Leiter 58,60 nicht kurzzuschließen. Die oberen Kavitäten 66 sind durch eine weitere Membran 72 verschlossen, auf der die Lochmasken, wie im Zusammenhang mit Fig. 1 beschrieben, ausgebildet sind.

Der Aufbau gemäß Fig. 4 mit den Thermopile-Elementen 56 als strahlungssensitive Elemente dient insbesondere zur Untersuchung von Spektren im Infrarot-Bereich. Wird das Spektrometer 10" Infrarotstrahlung ausgesetzt, so heizen sich die Thermopile-Elemente 56 solange auf, bis der Wärmeabfluss über das Substrat und der Wärmezufluss durch die Infrarotstrahlung, die wellenlängenselektiv durch die Strahlungsdurchlässe gelangt, im Gleichgewicht sind. Da die Strahlungsdurchlässe wellenselektiv arbeiten, heizen sich die Thermopile-Elemente 56 unterschiedlich stark auf und liefern demzufolge unterschiedliche Thermospannungen, die dann den Wellenlängen der jeweils empfangenen Infrarotstrahlung zugeordnet werden können.

Für die Herstellung der Lochmasken sollten Materialien verwendet werden, die Infrarotstrahlung reflektieren. Daher eignet sich insbesondere Metall (beispielsweise Aluminium), während Silizium beispielsweise ungeeignet ist, da es Infrarotstrahlung mit einer Wellenlänge oberhalb von 1300 nm durchlässt.

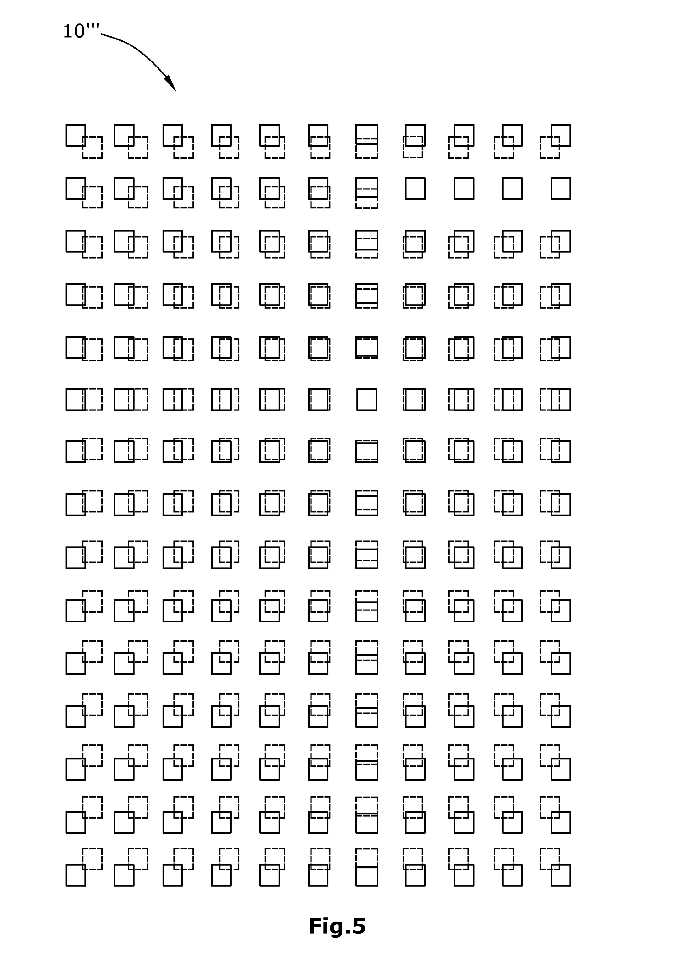

Fig. 5 zeigt eine Draufsicht auf eine Lochmaskenanordnung mit zweidimensionalem Lochmaskenversatz für die Erzeugung von in zwei Dimensionen unterschiedlich großen Strahlungsdurchlässen eines Festkörper-Spektrometers 10''' gemäß einem weiteren Ausführungsbeispiel. Bei einer derartigen Anordnung, bei der sich also die Strahlungsdurchlässe sowohl in der Breite als auch in der Länge um jeweils konstante Beträge ändern (bei Betrachtung benachbarter Strahlungsdurchlässe), kann auf die Polarisationsfilterung der zu untersuchenden Strahlung verzichtet werden.

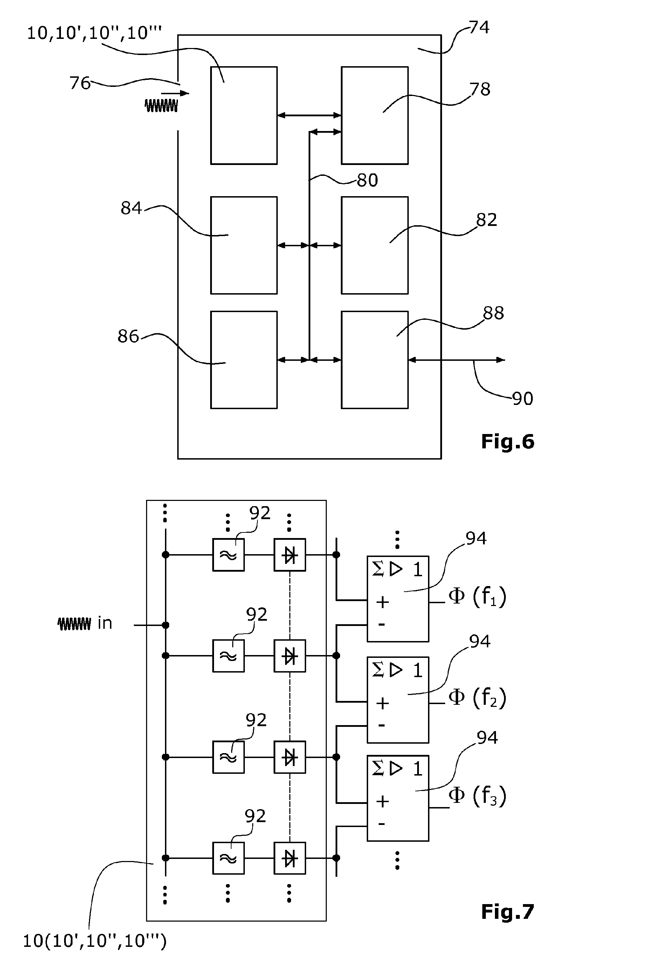

Fig. 6 zeigt schematisch und in Form eines Blockschaltdiagramms eine mögliche Beschaltung eines Festkörper-Spektrometers gemäß einem der zuvor beschriebenen Ausführungsbeispiele zu Kalibrationszwecken. Wie bereits oben erwähnt, kann im Vorhinein nicht zuverlässig ausgesagt werden, dass ein lokal festgelegter Strahlungsdurchlass des hergestellten Chips auch tatsächlich diejenige Strahlung hindurch lässt, wie es laut Herstellungsprozess und Anordnung des Strahlungsdurchlasses an sich beabsichtigt ist. Der Herstellungsprozess, nach dem die zueinander ein- oder zweidimensional versetzten Lochmasken erzeugt werden, garantiert, dass auf jeden Fall so viele Strahlungsdurchlässe mit denjenigen Abmessungen erzeugt worden sind, wie sie für den interessierenden Wellenlängenbereich und in der gewünschten Auflösung des Spektrometers erforderlich sind. Das bedeutet, dass man nach der Herstellung diejenigen Strahlungsdurchlässe definieren und identifizieren muss, die zur Untersuchung des interessierenden Spektrums erforderlich sind.

Eine Anordnung, die diese Kalibrierung durchführt, zeigt Fig. 6. Dabei ist mit 10 (bzw. 10', 10" und 10''') das Festkörper-Spektrometer gemeint. Dieses kann in einem Gehäuse 74 untergebracht sein. Dieses Gehäuse 74 weist ein optisches Fenster 76 auf, durch das die zu vermessende Strahlung auf das Spektrometer 10 (10',10",10''') fallen kann. Das optische Fenster muss für die interessierende Strahlung, d.h. zu vermessende Spektrum, durchlässig sein. Es kann ein Polarisationsfilter aufweisen. Ferner kann es nicht interessierende Strahlung und Strahlung mit störenden Raumrichtungen (Polarisation) abschirmen. Die Signale der strahlungsempfindlichen Elemente des Spektrometers 10 (10',10",10''') sind von der spektralen Zusammensetzung der einfallenden Strahlung abhängig.

Gemäß Fig. 6 werden die Ausgangssignale des Spektrometers 10 (10',10",10''') beispielsweise digital gewandelt, und zwar in einem Auswerteschaltkreis 78. Der Auswerteschaltkreis 78 ist in diesem Fall über einen Bus 80 mit einer CPU 82 verbunden. Diese CPU 82 erhält beispielsweise aus einem Speicher 84 Kalibrations- und Programmdaten.

Das abzuarbeitende Programm und die sonstigen fest vorgegebenen Daten werden von der CPU 82 ebenso dem Speicher 84 entnommen, der beispielsweise auch als Festwertspeicher ausgebildet sein kann. Variable Daten werden einem RAM 86 entnommen. Neben der hier beschriebenen Havard-Architektur sind selbstverständlich andere Architekturen wie beispielsweise eine Von-Neumann-Architektur möglich. Die CPU 82 kommuniziert über einen I/O-Schaltkreis 88 mit außerhalb der im Blockschaltbild gemäß Fig. 6 dargestellten Komponenten. Dies geschieht beispielsweise über einen Standardbus 90.

Die einzelnen strahlungsempfindlichen Elemente des Spektrometers 10 (10',10",10''') werden beispielsweise wie in Fig. 7 gezeigt miteinander verschaltet. In Fig. 7 ist ein Beispiel für die Extraktion der Intensitäten der Strahlung bei drei Wellenlängen und unter Verwendung von vier strahlungsempfindlichen Elementen gezeigt.

Gemäß Fig. 7 unterteilt sich die Anordnung in einen optischen linken Teil und einen elektrischen rechten Teil. Die optische Strahlung fällt, wie in Fig. 7 gezeigt, auf das Spektrometer 10 (10',10",10'''). Mit 92 sind die wellenlängenselektiven Filter gemeint, wie sie durch die Lochmaskenanordnung des Spektrometers 10 (10',10",10''') gebildet sind. Die optischen Filter 92 haben einen Hochpass-Charakter. In dem in Fig. 7 dargestellten Beispiel soll das oberste optische Filter 92 eine größere Grenzwellenlänge als das nächst untere optische Filter 92 haben. Dieses wiederum hat eine größere Grenzwellenlänge als das nächst untere optische Filter 92 (usw.).

Das verbleibende optische Signal wird durch einen optischen Wandler, nämlich durch die strahlungssensitiven Elemente des Spektrometers 10 (10',10",10''') in ein elektrisches Signal gewandelt. Das strahlungsempfindliche Element kann eine Fotodiode (pn-Diode), ein Thermopile-Element oder aber auch beispielsweise ein CCD-Element sein. Sofern notwendig, werden die Ausgangssignale dieser Elemente verstärkt, was in Fig. 7 nicht gezeigt ist. Die auf diese Weise gewonnenen Intensitätssignale werden auf Subtrahierschaltungen 94 gegeben, in denen durch die Subtraktion ein Differenzsignal mit Bandpass-Charakter in Bezug auf die einfallende Strahlung entsteht.

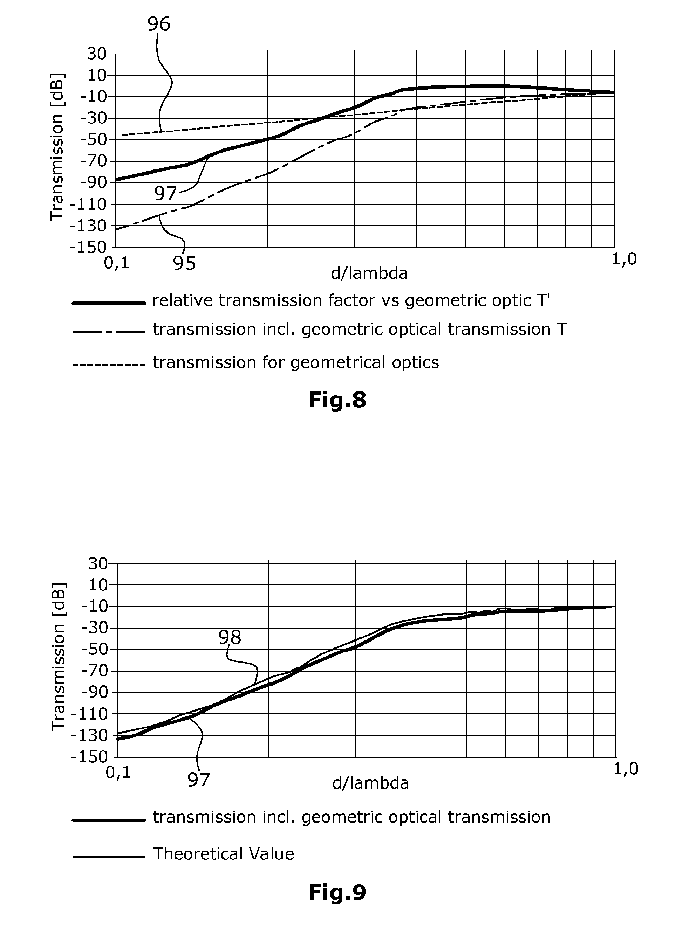

Anhand der Diagramme der Fign. 8 und 9 wird nachfolgend ein Beispiel für die Auswertung der Signale eines (kalibrierten) Festkörper-Spektrometers gemäß beispielsweise einem der Ausführungsbeispiele der Fign. 1, 2, 4 oder 5 beschrieben. Im Nachfolgenden wird ein beispielhaftes Verfahren angegeben, das es ermöglicht, aus den Ausgangssignalen der strahlungsempfindlichen Elemente, also beispielsweise auf die Fign. 1, 2 und 4 bezogen, aus den Dioden-bzw. Thermospannungen $U_i(\lambda)$ ein diskretisiertes Spektrum $S_i(\lambda)$ zu errechnen.

Die Diodenempfindlichkeit $E_i(\lambda)$ kann durch die in Fig. 8a angegebene Funktion für einen idealen Spalt als Strahlungsdurchlass angenähert werden. Die Werte entstammen der Publikation: P. Morse, P.J. Rubenstein; The Diffraction of Waves by Ribbons and by Slits; Physical Review; Vol. 54; Dec. 1st 1938; p. 895-898.

Der Wert d steht hierbei für die effektive Breite des Schlitzes und $\lambda$ für die Wellenlänge des einfallenden Lichtes. Hierbei wird angenommen, dass die Polarisation des Lichtes so gewählt ist, dass der E-Feld-Vektor parallel zum Schlitz ist. Wird die Wellennatur des Lichtes vernachlässig, so reduziert sich die Transmission des Lichtes durch den Spalt schon alleine aufgrund der mit schmaler werdendem d geringer werdenden Fläche. Dies ist in Kurve 96 dargestellt. Die Kurve 97 gibt den theoretischen Verlauf der Empfindlichkeit allein infolge der Wellennatur des Lichtes an. Hierbei wird die Reduktion der Transmission aufgrund von Effekten der geometrischen Optik, wie in Kurve 95 dargestellt, noch nicht berücksichtigt. Die Kurve 95 stellt die Kombination beider Effekte, also der Kurven 96 und 97 dar.

Für d>0,4 $\lambda$ folgt die Kurve 95 der Kurve 96. Die Transmission gehorcht für d>0,4 $\lambda$ der geometrischen Optik und ist insofern nicht wellenlängensensitiv. Für d<0,4 $\lambda$ folgt die Kurve einer Kombination der Kurven 97 und 96. In diesem Bereich ist die Kurve wellenlängensensitiv.

Bei diesen Betrachtungen wurde die Wellenlängenabhängigkeit des eigentlichen Fotoelementes - z.B. einer Si-Foto-Diode - vernachlässigt. Für kurze Wellenlängen passiert das Licht also zwar den Spalt; da die Fläche des Spalts jedoch proportional zur Spaltbreite ist, steigt die Empfindlichkeit der Fotodioden proportional zur Spaltbreite.

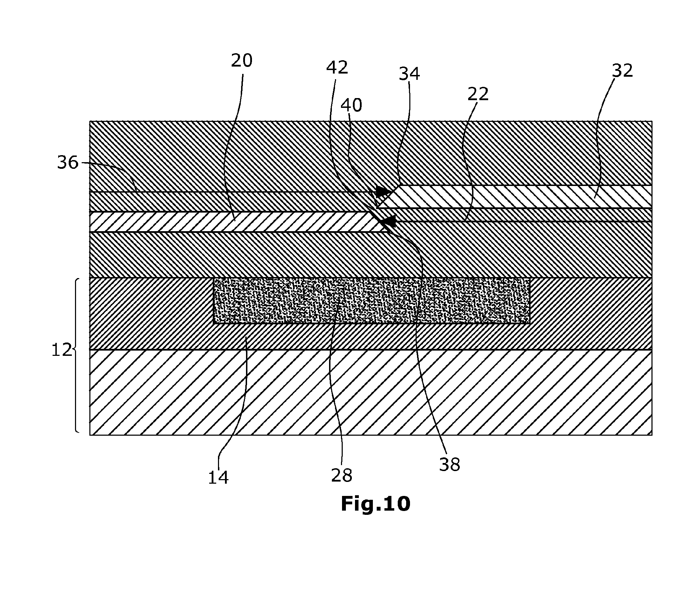

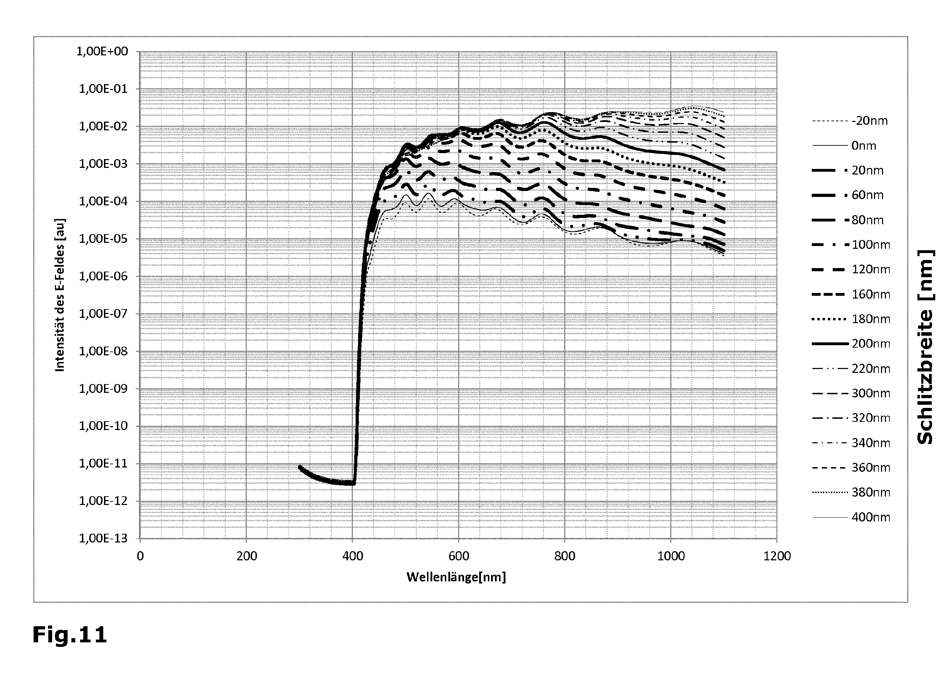

Eine Finite-Discrete-Time-Domain-(FDTD-)Simulation ergibt bei geeigneter Konstruktion z.B. entsprechend Fig. 10 und geeigneter Gestaltung aller Materialen eine Wellenlängenempfindlichkeit wie in Fig. 11 dargestellt. Aufgrund der Ausprägung des Fensters breiten sich die Wellen nach dem Durchtritt durch den Strahlungsdurchlass 42 zwischen den beiden Lochmasken 20, 32 im Substrat schräg aus. Dies gilt typischer Weise für alle Blenden mit Unterkanten auf unterschiedlichen Ebenen. In Fig. 10 ist zu erkennen, dass die einander gegenüberliegenden, einen Strahlungsdurchlass 42 definierenden Ränder 38, 40 der Fenster 20, 24 der beiden Lochmasken 20, 32 gegensinnig angeschrägt sind, wobei die Wahl der Orientierung der Anschrägungen (in der Lochmaske 32 nach oben rechts gerichtet und in der Lochmaske 20 nach unten rechts gerichtet - bezogen auf die Darstellung in Fig. 10) auch vertauscht sein kann. Entscheidend dabei ist, dass die Anschrägungen der besagten Ränder 38, 40 nicht parallel sondern in einem Winkel ungleich 0° verlaufen. Die Anschrägungen verlaufen insbesondere und vorzugsweise unter einem Winkel von 45° zur Normalen der Lochmasken. Dies vermeidet eben jene Interferenzen und Resonanzen, die im Stand der Technik, beispielsweise in US-A-2006/0044429, zur Erzeugung der Wellenlängenabhängigkeit genutzt werden, die aber für die erfindungsgemäße Vorrichtung kontraproduktiv sind. Ein fachkundiger Experte wird deshalb stets versuchen, die in Figur 11 erkennbare Restwelligkeit für die Wellenlängenempfindlichkeit einer erfindungsgemäßen Vorrichtung, die auf eben jene parasitären Resonanzen zurückzuführen ist, durch geeignete Simulationen, beispielsweise mittels FDTD-Simulation, und Konstruktions- und Materialanpassungen bereits in der Konstruktionsphase zu minimieren und dem Verlauf in Fig. 8 anzunähern.

Um die spätere Charakteristik eines ganzen Spektrometers berechnen zu können, ist es zunächst notwendig, die Charakteristik einer einzelnen Diode anzugeben.

Für kurze Wellenlängen $\lambda_e$ der einfallenden Strahlung hängt das Ausgangssignal der i-ten Diode proportional von der Spaltbreite $d_i$ derselben ab. Bei diesen kurzen Wellenlängen kann man also davon ausgehen, dass keine Abhängigkeit der Transmission durch den Spaltfilter von $\lambda_e$ vorliegt.

Diese Abhängigkeit besteht nur auf Grund der von der Spaltbreite $d_i$ und der Spaltlänge $l_i$ abhängigen Spalt-öffnungsfläche $A_i = d_i \cdot l_i$, die proportional zu $d_i$ mehr oder weniger Licht durchlässt.

Wird durch das einfallende Licht der Wert $\lambda_e > 2,5 \cdot d_i$ überschritten bzw. ist $d_i$ kleiner als $\lambda_e \cdot 0,4$, so wird die Transmission durch den Spaltfilter gedämpft. Diese Dämpfung $d(\lambda)$ beträgt in dem Bereich langer Wellenlängen mit

$\lambda_e > 2{,}5 * d_i$:-290dB*(d_i/ $\lambda_e$).

Eine solche Dämpfung entspricht einer Funktion:

$$D_i(\lambda_e) = \left(1 - \frac{1}{1+\frac{d_i}{\lambda_{ej}}}\right) * D_{0j} = \left(\frac{1}{1+\frac{\lambda_{ej}}{d_i}}\right) * D_{0j}$$

Hierbei stehen

$\lambda_e$ für die Wellenlänge der einfallenden Strahlung,

$\lambda_{ej}$ für die j-te Wellenlänge eines Paketes einfallender Strahlung aus diskreten Einzelwellenlängen,

$D_{0j}$ für das Sensorsignal bei Bestrahlung mit dieser j-ten Wellenlänge (dies spiegelt die Charakteristik des Sensorelementes wieder) und

$d_i$ für die Spaltbreite des i-ten Elementes (hierbei wird angenommen, dass alle Sensorelemente gleich sind).

Diese Formel wird im Folgenden Hochpass-Näherung genannt.

In Fig. 9 ist die Kurve der Fig. 8 im Vergleich zum theoretischen Verlauf 98 dargestellt.

Wie zu erkennen ist, nähert die Hochpass-Näherung das Verhalten bei polarisationsrichtiger Bestrahlung sehr gut an. Somit ergibt sich für ein diskretes, einfallendes Spektrum S bestehend aus Intensitäten $S_i$ der Einzelwellenlängen $\lambda_{ej}$:

$$S = \sum_{i=1}^{n} * S_i(\lambda_{ei})$$

ein Gesamtdiodensignal von:

$$D_j = \sum_{i=1}^{n}\left(\frac{1}{1+\frac{\lambda_{ei}}{d_j}}\right) * D_{0i} * S_i(\lambda_{ei})$$

Offensichtlich kann diese Gleichung in eine Matrizengleichung umgewandelt werden. Mit

$$\vec{D} = \left(D_1(S), D_2(S), D_3(S), \ldots D_{n-1}(S), D_n(S),\right)$$

und

$$\vec{S} = \left(S_1(\lambda_{e1}), S_2(\lambda_{e2}), S_3(\lambda_{e3}), \ldots S_1(\lambda_{e(n-1)}), S_1(\lambda_{en}),\right)$$

und

$$\overset{\leftrightarrow}{A} = \begin{pmatrix} A_{11} & A_{12} & A_{13} & \cdot & \cdot & A_{1(n-1)} & A_{1n} \\ A_{21} & A_{22} & A_{23} & \cdot & \cdot & A_{1(n-1)} & A_{1n} \\ A_{31} & A_{32} & A_{33} & \cdot & \cdot & A_{1(n-1)} & A_{1n} \\ \cdot & \cdot & \cdot & \cdot & \cdot & \cdot & \cdot \\ \cdot & \cdot & \cdot & \cdot & \cdot & \cdot & \cdot \\ A_{(n-1)1} & A_{(n-1)2} & A_{(n-1)3} & \cdot & \cdot & A_{(n-1)(n-1)} & A_{(n-1)n} \\ A_{n1} & A_{n2} & A_{n3} & \cdot & \cdot & A_{n(n-1)} & A_{nn} \end{pmatrix}$$

Mit

$$A_{ij} = \left( \frac{1}{1 + \dfrac{\lambda_{ei}}{d_j}} \right) * D_{0i}$$

In dem Fall lässt sich diese Gleichung für die Gesamtdiodensignale schreiben als:

$$\vec{D} = \overset{\leftrightarrow}{A} * \vec{S}$$

Es ist offensichtlich, dass diese Gleichung durch Multiplikation mit der zu A inversen Matrix A⁻¹ von links gelöst werden kann:

$$\overset{\leftrightarrow}{A}^{-1} * \vec{D} = \overset{\leftrightarrow}{A}^{-1} * \overset{\leftrightarrow}{A} * \vec{S} = \vec{S}$$

Voraussetzung für die Existenz dieser Matrix ist, dass sie regulär ist. Das bedeutet, dass ihr Rang gleich der Anzahl der Dioden und Spektralkomponenten n ist. Dies ist der Fall, wenn jeder Zeilenvektor zu jedem anderen Zeilenvektor bzw. jeder Spaltenvektor zu jedem anderen Spaltenvektor nicht kolinear ist.

Diese geforderte Regularität der n x n Matrix wird technisch durch n Spaltblenden (42) mit n unterschiedlichen Spaltbreiten (44) oberhalb der n Sensorelemente (30) in vorhersagbarer Weise erreicht. Durch diese Vorhersagbarkeit reduziert sich der Kalibrationsaufwand erheblich.

## Patentansprüche

1. Vorrichtung zur Erfassung des Spektrums elektromagnetischer Strahlung innerhalb eines vorgegebenen Wellenlängenbereichs, mit

    - einem Substrat (12),
    - einer oberhalb des Substrats (12) angeordneten ersten Lochmaske (20) aus einem für Strahlung innerhalb des vorgegebenen Wellenlängenbereichs undurchlässigen Material, wobei die erste Lochmaske (20) eine Vielzahl von ersten Fenstern (22) aufweist,
    - einer Vielzahl von in dem Substrat (12) angeordneten und für Strahlung bei jeweils einer verschiedenen Wellenlänge innerhalb des vorgegebenen Wellenlängenbereichs empfindlichen Sensorelementen, und
    - einer oberhalb der ersten Lochmaske (20) angeordneten, zweite Fenster (36) aufweisenden zweiten Lochmaske (32) aus einem für die Strahlung innerhalb des vorgegebenen Wellenlängenbereichs undurchlässigen Material,

- wobei die zweiten Fenster (36) der zweiten Lochmaske (32) überlappend mit den Fenstern (22) der ersten Lochmaske (20) angeordnet sind und gegenüberliegende Ränder der jeweils zwei sich überlappenden Fenster (22,36) der beiden Lochmasken (20,32) die Größe eines jeweils einem Sensorelement zugeordneten Strahlungsdurchlasses (42) zum Durchlassen von Strahlung mit einer innerhalb des vorgegebenen Wellenlängenbereichs liegenden Wellenlänge zu dem unterhalb des Strahlungsdurchlasses (42) angeordneten Sensorelement definieren,

- wobei für die Erfassung der Intensität von elektromagnetischer Strahlung bei jeder der mehreren, interessierenden Wellenlängen innerhalb des vorgegebenen Wellenlängenbereichs mindestens einer der Strahlungsdurchlässe (42) mit einer der jeweils interessierenden Wellenlänge zugeordneten Größe vorgesehen ist, und

- wobei die Fenster der ersten Lochmaske einen ersten Abstand und die Fenster der zweiten Lochmaske einen zweiten Abstand aufweisen, **dadurch gekennzeichnet dass** der erste Abstand und der zweite Abstand verschieden voneinander sind, so dass der Überlappungsgrad benachbarter Fenster der beiden Lochmasken variiert und damit die Strahlungsdurchlässe unterschiedlich groß sind.

2. Vorrichtung nach Anspruch 1, **dadurch gekennzeichnet, dass** mindestens zwei benachbarte Fenster (36) der zweiten Lochmaske (32) mit jeweils einem Fenster (22) der ersten Lochmaske (20) überlappend angeordnet sind.

3. Vorrichtung nach Anspruch 1, **dadurch gekennzeichnet, dass** mindestens für eine Teilmenge der Fenster (36) gilt, dass jedes dieser Fenster (36) der zweiten Lochmaske (32) mit jeweils einem Fenster (22) der ersten Lochmaske (20) überlappend angeordnet ist.

4. Vorrichtung nach einem der Ansprüche 1 bis 3, **dadurch gekennzeichnet, dass** das Material der ersten Lochmaske (20) und/oder der zweiten Lochmaske (32) ein Metall oder polykristallines Silizium oder insbesondere silizidiertes polykristallines Silizium aufweist.

5. Vorrichtung nach einem der Ansprüche 1 bis 4, **dadurch gekennzeichnet, dass** die strahlungsempfindlichen Sensorelemente (56) jeweils zwei unterschiedliche, elektrisch leitende und in Kontakt miteinander stehende, bei Empfang von elektromagnetischer Strahlung innerhalb des vorgegebenen Wellenlängenbereichs einen veränderbaren elektrischen Parameter (insbesondere erzeugter Strom oder erzeugte Spannung oder elektrischer Widerstand oder Kapazität) erzeugende Materialien (58, 60) aufweisen, wobei die Größe der Parameteränderung von der Intensität der Strahlung abhängig ist.

6. Vorrichtung nach einem der Ansprüche 1 bis 5, **dadurch gekennzeichnet, dass** die ersten und zweiten Fenster (22,36) der beiden Lochmasken (20,32) sich jeweils über Flächen erstrecken, die längs zweier zueinander rechtwinkliger Aufspannachsen (50,52) aufgespannt sind, dass die Abmessungen der ersten und zweiten Fenster (22,36) in zumindest einer gemeinsamen ersten Achse (50) der beiden Aufspannachsen (50,52) jeweils von einem ersten und einem zweiten Begrenzungsrand (38,40) des betreffenden Fensters (22,36) begrenzt sind, wobei, in einer gemeinsamen ersten Aufspannachse (50) betrachtet, jeder Strahlungsdurchlass (42) von einem ersten Begrenzungsrand (38) eines ersten Fensters (22) der ersten Lochmaske (20) und einem zweiten Begrenzungsrand (40) eines das erste Fenster (22) überlappenden zweiten Fensters (36) der zweiten Lochmaske (32) begrenzt ist, und dass der erste Abstand der ersten Begrenzungsränder (38) jeweils benachbarter erster Fenster (22) der ersten Lochmaske (20) von dem zweiten Abstand der zweiten Begrenzungsränder (40) jeweils benachbarter zweiter Fenster (36) der zweiten Lochmaske (32) verschieden ist.

7. Vorrichtung nach Anspruch 6, **dadurch gekennzeichnet, dass** oberhalb der Anordnung der Lochmasken (20,32) ein Polarisationsfilter (48) zum Abschirmen von Strahlung mit elektromagnetischen Wellen, deren E-Feld-Vektor rechtwinklig zur ersten Aufspannachse (50) verläuft, und zum Hindurchlassen von Strahlung mit elektromagnetischen Wellen, deren E-Feld-Vektor parallel zur ersten Aufspannachse (50) verläuft.

8. Vorrichtung nach Anspruch 6, **dadurch gekennzeichnet, dass** die Abmessungen der ersten und zweiten Fenster (22,36) auch in der gemeinsamen zweiten Achse (52) der beiden Aufspannachsen (50,52) jeweils von einem dritten und einem vierten Begrenzungsrand des betreffenden Fensters (22,36) begrenzt sind, wobei, in der gemeinsamen zweiten Aufspannachse (52) betrachtet, jeder Strahlungsdurchlass (42) von einem dritten Begrenzungsrand des ersten Fensters (22) der ersten Lochmaske (20) und einem vierten Begrenzungsrand eines das erste Fenster (22) überlappenden zweiten Fensters (36) der zweiten Lochmaske (32) begrenzt ist.

9. Vorrichtung nach einem der Ansprüche 1 bis 8, **dadurch gekennzeichnet, dass** die Sensorelemente als Fotodioden (30), insbesondere pn-Dioden, oder als IR-Dioden oder als Thermopile-Elemente (56) ausgebildet sind.

10. Vorrichtung nach einem der Ansprüche 1 bis 9,
**dadurch gekennzeichnet,**
**dass** in dem Substrat (12) von dessen Oberseite (16) aus ein mit ersten Ladungsträgern von einem ersten Leitungstyp versehenes Gebiet (14) ausgebildet ist, wobei in dem Gebiet (14) mit den ersten Fenstern (22) der ersten Lochmaske (20) fluchtende und innerhalb der Fenster (22) freiliegende Teilgebiete (28) mit zweiten Ladungsträgern von einem dem ersten Leitungstyp entgegengesetzten zweiten Leitungstyp ausgebildet sind, die mit den jeweils angrenzenden Bereichen des Gebiets (14) aus den ersten Ladungsträgern ein Sensorelement (30), insbesondere eine Fotodiode bilden.

11. Vorrichtung nach einem der Ansprüche 1 bis 10, **dadurch gekennzeichnet,**
**dass** die beiden Lochmasken (20, 32) aus einem Material bestehen bzw. mit einem Material beschichtet sind, das für die interessierende Strahlung nicht reflektiv und/oder nicht refraktiv und/oder nicht durchlässig ist und/oder absorbierend wirkt.

## Claims

1. A device for detecting the spectrum of electromagnetic radiation within a specified wavelength range, comprising

   - a substrate (12),
   - a first aperture mask (20) arranged above the substrate (12) and made of a material being non-transmissive to radiation within the specified wavelength range, the first aperture mask (20) comprising a plurality of first windows (22),
   - a plurality of sensor elements arranged in the substrate (12) and being sensitive to radiation of respectively a different wavelength within the specified wavelength range, and
   - a second aperture mask (32) arranged above the first aperture mask (20) and comprising second windows (36), said second aperture mask being made of a material being non-transmissive to the radiation within the specified wavelength range,
   - wherein the second windows (36) of the second aperture mask (32) are arranged to overlap with the windows (22) of the first aperture mask (20), and wherein opposite edges of the respective two overlapping windows (22,36) of the two aperture masks (20,32) define the size of a radiation passage (42) assigned to a respective sensor element and designed for allowing radiation of a wavelength within the specified wavelength range to pass to the sensor element arranged below the radiation passage (42),
   - wherein, for detecting the intensity of electromagnetic radiation at each of the plurality of wavelengths of interest within the specified wavelength range, at least one of the radiation passages (42) is provided, having a size assigned to one of the respective wavelengths of interest, and
   - wherein the windows of the first aperture mask have a first distance and the windows of the second aperture mask have a second distance,

   **characterized in that** the first distance and the second distance are different from each other so that the degree of overlap of adjacent windows of the two aperture masks is varying and the radiation passages thus have different sizes.

2. The device according to claim 1, **characterized in that** at least two adjacent windows (36) of the second aperture mask (32) are arranged to overlap with respectively one window (22) of the first aperture mask (20).

3. The device according to claim 1, **characterized in that**, for at least a subset of the windows (36), it applies that each of these windows (36) of the second aperture mask (32) is arranged to overlap with respectively one window (22) of the first aperture mask (20).

4. The device according to any one of claims 1 to 3, **characterized in that** the material of the first aperture mask (20) and/or of the second aperture mask (32) comprises a metal or a polycrystalline silicon or particularly a silicided polycrystalline silicon.

5. The device according to any one of claims 1 to 4, **characterized in that** the radiation-sensitive sensor elements (56) comprise respectively two different, electrically conductive and mutually contacting materials (58,60) which, upon receipt of electromagnetic radiation within the predetermined wavelength range, generate a variable electric parameter (particularly generated current or generated voltage or electric resistance or capacity), the amount of the parameter variation being dependent on the intensity of the radiation.

6. The device according to any one of claims 1 to 5, **characterized in that** the first and second windows (22,36) of the two aperture masks (20, 32) each extend across surfaces which are spanned along two mutually right-angled spanning axes (50,52), that the sizes of the first and second windows (22,36) in at least one common first axis (50) of the two spanning axes (50,52) are respectively delimited at least by a first and a second delimiting edge (38,40) of the respective window (22,36), wherein, when viewed in a common first spanning axis (50), each radiation passage (42) is delimited by a first delimiting edge (38) of a first window (22) of the first aperture mask (20) and by a second delimiting edge (40) of a second window (36), overlapping with the first window (22), of the second aperture mask (32), and that the first distance of the first delimiting edges (38) of respectively adjacent first windows (22) of the first aperture mask (20) is different from the second distance of the second delimiting edges (40) of respectively adjacent second windows (36) of the second aperture mask (32).

7. The device according to claim 6, **characterized in that**, above the arrangement of the aperture masks (20,32), a polarization filter (48) is arranged for shielding radiation with electromagnetic waves whose E-field vector extends at a right angle to the first spanning axis (50), and for allowing the passage of radiation whose E-field vector extends parallel to the first spanning axis (50).

8. The device according to claim 6, **characterized in that**, also in the common second axis (52) of the two spanning axes (50,52), the sizes of the first and second windows (22,36) are respectively delimited by a third and a fourth delimiting edge of the respective window (22,36), wherein, when viewed in the common second spanning axis (52), each radiation passage (42) is delimited by a third delimiting edge of the first window (22) of the first aperture mask (20) and by a fourth delimiting edge of a second window (36), overlapping with the first window (22), of the second aperture mask (32).

9. The device according to any one of claims 1 to 8, **characterized in that** the sensor elements are designed as photodiodes (30), particularly p-n diodes, or as IR diodes or as thermopile elements (56).

10. The device according to any one of claims 1 to 9, **characterized in that**, in the substrate (12), from the top side (16) thereof, an area (14) is formed which is provided with first charge carriers of a first conductive type, wherein partial areas (28) are formed in said area (14) which are in alignment with the first windows (22) of the first aperture mask (20) and are exposed within the windows (22), said partial areas being provided with second charge carriers of a second conductive type opposite to the first conductive type and, together with the respective adjacent regions of said area (14) including the first charge carriers, forming a sensor element (30), particularly a photodiode.

11. The device according to any one of claims 1 to 10, **characterized in that** the two aperture masks (20,32) are made of a material and respectively are coated with a material which, for the radiation of interest, is not reflective and/or not refractive and/or not transmissive and/or has an absorbing effect.

## Revendications

1. Dispositif pour détecter le spectre d'un rayonnement électromagnétique dans une plage de longueurs d'onde prédéterminée, comprenant

   - un substrat (12),
   - un premier masque perforé (20) disposé au-dessus du substrat (12) et fait d'une matière opaque pour le rayonnement contenu dans la plage de longueurs d'onde prédéterminée, le premier masque perforé (20) présentant une pluralité de premières fenêtres (22),
   - une pluralité d'éléments capteurs disposés dans le substrat (12), dont chacun est sensible au rayonnement d'une longueur d'onde différente contenue dans la plage de longueurs d'onde prédéterminée, et
   - un second masque perforé (32) disposé au-dessus du premier masque perforé (20), présentant des secondes fenêtres (36) et fait d'une matière opaque au rayonnement dans la plage de longueurs d'onde prédéterminée,
   - dans lequel les secondes fenêtres (36) du second masque perforé (32) sont à chevauchement par rapport aux fenêtres (22) du premier masque perforé (20) et les bords opposés de deux fenêtres à chevauchement mutuel (22, 36) des deux masques perforés (20, 32) définissent la grandeur d'un passage de rayonnement (42) associé à un élément capteur, pour laisser passer un rayonnement d'une longueur d'onde contenue dans la plage de longueurs d'onde prédéterminée et le laisser atteindre l'élément capteur disposé au-dessous du passage de rayonnement (42),

- dans lequel, pour la détection de l'intensité d'un rayonnement électromagnétique pour chacune des multiples longueurs d'ondes intéressantes contenues dans la plage de longueurs d'onde prédéterminée, au moins l'un des passages de rayonnement (42) est réalisé avec une grandeur correspondan4t à une des longueurs d'ondes intéressantes, et

- dans lequel les fenêtres du premier masque perforé présentent un premier écartement et les fenêtres du second masque perforé présentent un second écartement,

**caractérisé en ce que** le premier écartement et le second écartement sont différents l'un de l'autre, de sorte que le degré de chevauchement de fenêtres voisines appartenant aux deux masques perforés varie et que, de ce fait, les passages de rayonnement sont de différentes grandeurs.

2. Dispositif selon la revendication 1, **caractérisé en ce qu'**au moins deux fenêtres voisines (36) du second masque perforé (32) sont disposées à chevauchement par rapport à une fenêtre (22) du premier masque perforé (20).

3. Dispositif selon la revendication 1, **caractérisé en ce qu'**au moins pour une partie des fenêtres (36), chacune de ces fenêtres (36) du second masque perforé (32) est disposée à chevauchement par rapport à une fenêtre (22) du premier masque perforé (20).

4. Dispositif selon l'une des revendications 1 à 3, **caractérisé en ce que** la matière du premier masque perforé (20) et/ou du second masque perforé (32) comprend un métal ou du silicium polycristallin, ou en particulier du silicium polycristallin siliciuré.

5. Dispositif selon l'une des revendications 1 à 4, **caractérisé en ce que** les éléments capteurs sensibles au rayonnement (56) présentent chacun deux matières différentes (58, 60), conductrices de l'électricité et en contact entre elles, et qui, à réception d'un rayonnement électromagnétique dans la plage de longueurs d'onde prédéterminée, produisent un paramètre électrique modifiable (en particulier un courant produit ou une tension produite, une résistance électrique ou une capacité), la grandeur de variation du paramètre étant fonction de l'intensité du rayonnement.

6. Dispositif selon l'une des revendications 1 à 5, **caractérisé en ce que** les premières et secondes fenêtres (22, 36) des deux masques perforés (20, 32) se déploient sur des surfaces qui s'étendent le long de deux axes d'extension perpendiculaires (50, 52), **en ce que** les dimensions des premières et secondes fenêtres (22, 36) sont limitées chacune dans au moins un premier axe (50) des deux axes d'extension (50, 52) qui leur est commun par un premier et un second bord de limitation (38, 40) de la fenêtre (22, 36) considérée, cependant que, vu dans un premier axe d'extension commun (50), chaque passage de rayonnement (42) est limité par un premier bord de limitation (38) d'une première fenêtre (22) du premier masque perforé (20) et par un second bord de limitation (40) d'une seconde fenêtre (36) qui est à chevauchement par rapport à la première fenêtre (22) du second masque perforé (32), et **en ce que** le premier écartement des premiers bords de limitation (38) de la première fenêtre voisine correspondante (22) du premier masque perforé (20) est différent du second écartement des seconds bords de limitation (40) de la seconde fenêtre voisine correspondante (36) du second masque perforé (32).

7. Dispositif selon la revendication 6, **caractérisé en ce qu'**au-dessus du groupe des masques perforés (20, 32), s'étend un filtre polarisant (48) servant à arrêter un rayonnement qui contient des ondes électromagnétiques dont le vecteur de champ E s'étend perpendiculairement au premier axe d'extension (50) et à laisser passer un rayonnement contenant des ondes électromagnétiques dont le vecteur de champ E s'étend parallèlement au premier axe d'extension (50).

8. Dispositif selon la revendication 6, **caractérisé en ce que** les dimensions des premières et secondes fenêtres (22, 36) sont de même limitées dans le second axe (52) des deux axes d'extension (50, 52) qui leur est commun, pour chacune, par un troisième et un quatrième bord de limitation de la fenêtre correspondante (22,36), cependant que, vu dans le second axe d'extension commun (52), chaque passage de rayonnement (42) est limité par un troisième bord de limitation de la première fenêtre (22) du premier masque perforé (20) et par un quatrième bord de limitation d'une seconde fenêtre (36) du second masque perforé (32) qui est à chevauchement par rapport à la première fenêtre (22).

9. Dispositif selon l'une des revendications 1 à 8, **caractérisé en ce que** les éléments capteurs sont constitués par des photodiodes (30), en particulier par des diodes pn, des diodes IR ou des diodes thermopiles (56).

10. Dispositif selon l'une des revendications 1 à 9, **caractérisé en ce que**, dans le substrat (12), est formée, à partir de sa face supérieure (16), une région (14) présentant des premiers porteurs de charge d'un premier type de conduction, cependant que, dans la région (14), sont formées des régions partielles (28) alignées avec les premières fenêtres (22) du premier masque perforé (20) et ouvertes dans les limites des fenêtres (22), et qui présentent des porteurs de charge d'un second type de conduction, inverse du premier type de conduction, ces régions partielles formant avec les zones respectivement adjacentes de la région (14) faites des premiers porteurs de charge un élément capteur (30), en particulier une photodiode.

11. Dispositif selon l'une des revendications 1 à 10, **caractérisé en ce que** les deux masques perforés (20, 32) sont composés ou revêtus d'une matière qui n'a pas de capacité de réflexion et/ou de réfraction et/ou de transmission et/ou d'absorption du rayonnement intéressant.

**Fig.1**

**Fig.2**

EP 2 705 535 B1

**Fig.3**

**Fig.4**

10''''

**Fig.5**

10,10',10'',10'''
76
74
78
80
84
82
86
88
90

**Fig.6**

92
94
Φ (f₁)
92
94
Φ (f₂)
92
94
Φ (f₃)

in

10(10',10'',10''')

**Fig.7**

**Fig.8**

**Fig.9**

**Fig.10**

**Schlitzbreite [nm]**

Legend:
- -20nm
- 0nm
- 20nm
- 60nm
- 80nm
- 100nm
- 120nm
- 160nm
- 180nm
- 200nm
- 220nm
- 300nm
- 320nm
- 340nm
- 360nm
- 380nm
- 400nm

Y-axis: Intensität des E-Feldes [au]
X-axis: Wellenlänge[nm]

**Fig.11**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1475963 A
- EP 1517374 A
- US 20060044429 A
- US 20100176280 A
- WO 2009106316 A
- US 20080170143 A
- EP 2251718 A

**In der Beschreibung aufgeführte Nicht-Patentliteratur**

- **P. MORSE ; P.J. RUBENSTEIN.** The Diffraction of Waves by Ribbons and by Slits. *Physical Review,* vol. 54, 895-898